# FASCICULE DE BREVET EUROPEEN

(11) **EP 3 134 456 B1**
(45) Date de publication et mention de la délivrance du brevet: **26.06.2019**
(21) Numéro de dépôt: 15725750.2
(22) Date de dépôt: 16.04.2015
(51) Int. Cl.: H01L 23/29, H01L 21/56, H05K 3/00, H05K 1/03, C08K 3/013, C08G 59/68, H01B 3/40, C08G 59/42

(54) **UTILISATION D'UNE COMPOSITION DE RESINE THERMODURCISSABLE DE TYPE VITRIMERE POUR LA FABRICATION DE PIECES D'ISOLATION ELECTRIQUE**
VERWENDUNG EINER DUROPLASTISCHEN VITRIMEREN HARZZUSAMMENSETZUNG ZUR HERSTELLUNG VON ELEKTRISCHEN ISOLATIONSTEILEN
USE OF A COMPOSITION OF A VITRIMER-TYPE THERMOSETTING RESIN FOR THE PRODUCTION OF ELECTRICAL INSULATING PARTS

(30) Priorité: 24.04.2014 FR 1453679
(43) Date de publication de la demande: 01.03.2017
(73) Titulaire: Arkema France, 92700 Colombes (FR)
(72) Inventeur: DISSON, Jean-Pierre, 69390 Vernaison (FR); DUQUENNE, Christophe, 75010 Paris (FR); MELAS, Michel, 69250 Montanay (FR)
(74) Mandataire: Bonnel, Claudine
(86) Numéro de dépôt international: PCT/FR2015/051034
(87) Numéro de publication internationale: WO 2015/162361

(56) Documents cités:
- WO-A1-99/43729
- WO-A1-2010/031445
- WO-A1-2012/152859
- MATHIEU CAPELOT ET AL: "Catalytic Control of the Vitrimer Glass Transition", ACS MACRO LETTERS, vol. 1, no. 7, 17 juillet 2012 (2012-07-17), pages 789-792, XP055158320, ISSN: 2161-1653, DOI: 10.1021/mz300239f

## Description

### DOMAINE DE L'INVENTION

La présente invention se rapporte à l'utilisation, pour la fabrication de pièces d'isolation électrique, d'une composition renfermant, outre une résine thermodurcissable de type époxy et un durcisseur, au moins un catalyseur organique non métallique d'effet vitrimère. Cette composition permet la fabrication de résines vitrimères, c'est-à-dire de résines déformables à l'état thermodurci, qui présentent des propriétés adaptées à une utilisation dans des pièces d'isolation électrique.

### ARRIERE-PLAN TECHNIQUE

Les isolateurs électriques sont des pièces électrotechniques destinées à fixer, maintenir ou soutenir des conducteurs électriques nus. On trouve des isolateurs en particulier sur les lignes à haute tension, où ils assurent l'isolation entre les conducteurs et les pylônes. Les isolateurs sont également employés pour isoler des connecteurs de toute taille, qui vont des connecteurs de transformateurs à haute tension à des connecteurs de petits circuits électroniques comme par exemple de la petite câblerie dans des véhicules.

Parmi les différents matériaux utilisés dans la fabrication de ces isolateurs, on peut notamment citer les résines thermodurcies de type époxy, qui sont obtenues à partir d'une formulation de résine époxy, d'un durcisseur et généralement d'un catalyseur de type amine tertiaire, suivant un procédé de polycondensation qui a l'avantage de ne pas générer de sous-produits liquides ou gazeux. Ces résines thermodurcies permettent le moulage de pièces complexes sans formation de bulles susceptibles de détériorer la rigidité diélectrique du matériau isolant. Ce moulage est par exemple effectué par coulée gravitaire, par injection basse pression. Elles peuvent également être utilisées dans des pièces composites et plus particulièrement pour l'imprégnation de fibres dans un procédé de fabrication d'isolateurs par enroulement filamentaire. Ces résines époxy sont également utilisées sous forme d'adhésifs, de joints, de revêtements ou de masses de scellement. Elles permettent d'obtenir des matériaux présentant une résistivité volumique et de surface élevée.

Le choix d'une formulation de résine époxy repose notamment sur les propriétés diélectriques que l'on cherche à obtenir, ainsi que la résistance physique, chimique et mécanique que doit présenter ce matériau dans les conditions d'utilisation envisagées (température, humidité, vibrations...). La sélection de la formulation adaptée tient également compte des conditions de durcissement de la résine, qui ne doit pas libérer trop de chaleur, se rétracter ou développer des contraintes internes.

Les formulations de résine époxy renferment habituellement des charges, sous forme fibreuse ou non, qui permettent d'améliorer les propriétés mécaniques et la dissipation de chaleur du matériau. Il peut s'agir de charges inorganiques telles que la silice, l'alumine ou le verre ou de charges organiques telles que le poly(téréphthalate d'éthylène).

A titre d'exemples de formulations de résine époxy utilisées pour produire des systèmes d'isolation électrique, on peut citer notamment celles décrites dans le document WO 2010/031445, qui comprennent une résine époxy, un durcisseur, une charge minérale, et de manière optionnelle des additifs parmi lesquels un catalyseur pour faciliter la réaction entre la résine époxy et le durcisseur. Le catalyseur est choisi de préférence parmi les amines tertiaires ou les composés imidazole substitués.

Dans le document WO 99/43729, il a été proposé également des compositions thermodurcissables qui peuvent être utilisées dans le domaine électrique. Ces compositions, comprenant deux types de résines époxy et des charges minérales en quantité importante, sont basées sur l'utilisation d'une combinaison d'un durcisseur anhydride et d'un accélérateur de durcissement spécifique de type imidazole, amidine ou amino-pyridine répondant à des structures (I) à (IV) particulières.

Les isolateurs, qui constituent des organes de sécurité sur les circuits électriques, sont soumis à des cahiers des charges très exigeants en termes d'isolation électrique, de durée de vie et de tenue à l'endommagement. Or, un inconvénient typiquement associé à l'utilisation de résines époxy est leur tendance à se fissurer soit à basse température, du fait de la différence des coefficients de dilatation thermique de la résine époxy et du métal qu'elle enrobe, soit à plus haute température, du fait de la vaporisation de l'eau piégée dans la résine. Ces fissures favorisent le cheminement des arcs électriques qui peuvent générer un incendie. La formation de ces fissures est liée à la densité élevée de réticulation des résines époxy, qui en fait un matériau peu déformable et peu tolérant aux contraintes thermiques. Leur propagation est favorisée par le caractère peu ductile des résines époxy.

Compte tenu de l'impossibilité de refondre les résines époxy, dans la mesure où les réactions ayant conduit à leur formation sont irréversibles, il est impossible de réparer ces matériaux une fois qu'ils sont fissurés. De ce fait, l'ensemble de l'installation constituée de l'isolateur, des connecteurs et des câbles doit être démontée et remplacée, ce qui occasionne d'importants coûts de maintenance, et de séparation résine / métal dans des centres de recyclage spécialisés.

Il subsiste donc le besoin de disposer de matériaux présentant les propriétés avantageuses des résines époxy sans leurs inconvénients, c'est-à-dire qui présentent de de bonnes propriétés mécaniques et isolantes tout en étant capables de relaxer par simple traitement thermique les contraintes générées lors de leur fonctionnement par des écarts de température, par des efforts mécaniques ou par des agressions chimiques. Il serait ainsi possible de réparer entièrement ou partiellement les fissures formées dans le matériau.

Or, il est apparu à la Demanderesse que ce besoin pouvait être satisfait en utilisant, en lieu et place des résines époxy classiquement employées dans les isolateurs, des matériaux vitrimères.

Les matériaux vitrimères présentent à la fois les propriétés mécaniques et de résistance aux solvants des résines thermodurcies et la capacité à être refaçonnés et/ou réparés des matériaux thermoplastiques. Ces matériaux polymères sont capables de passer indéfiniment d'un état solide à un liquide viscoélastique, comme le verre.

Les propriétés particulières des vitrimères sont liées à la capacité de leur réseau à se réorganiser au-delà d'une certaine température, sans modifier le nombre de liaisons intramoléculaires ni se dépolymériser, sous l'effet de réactions d'échange interne. Ces réactions entraînent une relaxation des contraintes au sein du matériau qui devient malléable, tout en conservant son intégrité et en restant insoluble dans tout solvant. Ces réactions sont rendues possibles par la présence d'un catalyseur. Dans le cas des vitrimères de type époxy-anhydride, comme dans celui des vitrimères de type époxy-acide, obtenus à partir d'une résine thermodurcissable de type époxy et d'un durcisseur de type anhydride ou acide respectivement, il a été suggéré d'utiliser comme catalyseur un sel métallique de zinc, d'étain, de magnésium, de cobalt, de calcium, de titane ou de zirconium, de préférence l'acétylacétonate de zinc (WO 2012/101078 ; WO 2011/151584). Il a été proposé également dans le document WO 2012/152859 de mettre en oeuvre un catalyseur de nature organique comme des guanidines dans des composés hybrides thermodurs/supramoléculaires dont les propriétés sont utilisables dans le domaine des systèmes d'isolation électrique. Il a en outre été proposé d'utiliser le TBD comme catalyseur dans des systèmes à base de résine époxy et durcisseur acide (M. CAPELOT et al., ACS Macro Lett. 2012, 1, 789-792). Cependant, ce document ne décrit pas l'utilisation de ce système pour la fabrication de pièces électriques.

Les inventeurs ont précisément démontré que l'utilisation de catalyseurs organiques non métalliques permettait d'obtenir des matériaux vitrimères utiles pour la fabrication d'isolateurs.

### DEFINITIONS

Par résine « thermodurcissable », on entend un monomère, oligomère, prépolymère, polymère ou toute macromolécule apte à être réticulé chimiquement. On entend plus préférentiellement un monomère, oligomère, prépolymère, polymère ou toute macromolécule apte à être réticulé chimiquement lorsqu'il est mis à réagir avec un durcisseur (encore appelé réticulant) en présence d'une source d'énergie, par exemple de chaleur ou de rayonnement, et éventuellement d'un catalyseur.

Par résine « thermodurcie » ou « à l'état thermodurci », on entend une résine thermodurcissable réticulée chimiquement de sorte que son point de gel soit atteint ou dépassé. Par "point de gel", on entend le degré de réticulation à partir duquel la résine n'est quasiment plus soluble dans les solvants. Toute méthode classiquement utilisée par l'homme du métier pourra être mise en oeuvre pour le vérifier. On pourra par exemple mettre en oeuvre le test décrit dans la demande WO 97/23516 page 20. Une résine est considérée comme thermodurcie au sens de l'invention dès lors que son taux de gel, c'est-à-dire le pourcentage de sa masse résiduelle après mise en solvant relativement à sa masse initiale avant mise en solvant, est égal ou supérieur à 75 %.

Le terme « durcisseur » désigne un agent réticulant apte à réticuler une résine thermodurcissable. Il s'agit ici d'un composé généralement polyfonctionnel, porteur de fonctions de type anhydride et/ou acide capables de réagir avec des fonctions réactives portées par la résine.

Par "catalyseur organique non métallique" on entend un catalyseur comportant au moins des atomes de carbone et d'hydrogène, et éventuellement d'autres atomes choisis parmi N, O, S et/ou P. Cette définition exclut par conséquent les catalyseurs organométalliques ainsi que les sels métalliques organiques, renfermant notamment des atomes de zinc, d'étain, de magnésium, de cobalt, de calcium, de titane et/ou de zirconium.

Par "catalyseur d'effet vitrimère", on entend un catalyseur qui facilite les réactions d'échange interne au sein d'une résine thermodurcie de façon à la rendre déformable.

Ce catalyseur pourra satisfaire en particulier au test décrit dans la publication WO2012/101078, aux pages 14-15.

Lorsqu'il est fait référence à des intervalles, les expressions du type « allant de ... à ... » incluent les bornes de l'intervalle. Les expressions du type « compris entre ... et ... » excluent les bornes de l'intervalle.

### RESUME DE L'INVENTION

L'invention a pour objet l'utilisation, pour la fabrication de pièces d'isolation électrique, d'une composition renfermant, outre une résine thermodurcissable de type époxy et un durcisseur, au moins un catalyseur organique non métallique d'effet vitrimère à une teneur allant de 0,1 à 10% en mol, relativement à la quantité molaire de fonctions époxy contenues dans la résine thermodurcissable.

Selon l'invention, le durcisseur est choisi parmi les anhydrides d'acide carboxylique comportant au moins une fonction -C(O)-O-C(O)-

Selon l'invention, le catalyseur d'effet vitrimère est choisi parmi les composés de type guanidine répondant à la formule (I) : 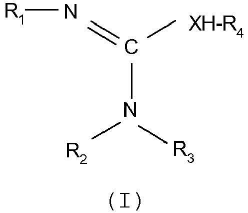 dans laquelle :
X désigne un atome d'azote,
R₁ désigne un atome d'hydrogène, un groupe alkyle en C₁-C₆ ou un groupe phényle pouvant être substitués par un groupe alkyle en C₁-C₄,
R₂, R₃ et R₄ désignent indépendamment un atome d'hydrogène, un groupe alkyle en C₁-C₆, ou un groupe phényle pouvant être substitués par un groupe alkyle en C₁-C₄, ou un groupe acétyle,
ou R₁ et R₂ forment ensemble et avec les atomes auxquels ils sont liés un hétérocycle insaturé et/ou R₃ et R₄ forment ensemble et avec les atomes auxquels ils sont liés un hétérocycle saturé ou insaturé.

L'invention a également pour objet un procédé de fabrication de pièces d'isolation électrique, comprenant
a) la préparation à chaud d'une composition renfermant une résine thermodurcissable de type époxy, un durcisseur et au moins un catalyseur organique non métallique d'effet vitrimère, à partir de la composition telle que définie précédemment,
b) éventuellement, la mise en contact de la composition issue de l'étape (a) avec au moins un élément électriquement conducteur,
c) la mise en forme de la composition issue de l'étape a),
d) l'application d'une énergie permettant le durcissement de la résine,
e) le refroidissement de la résine thermodurcie.
Elle a encore pour objet une pièce d'isolation électrique obtenue suivant ce procédé.

### DESCRIPTION DETAILLEE

Comme indiqué précédemment, la composition utilisée selon l'invention renferme un catalyseur organique non métallique d'effet vitrimère. Il est entendu que ce catalyseur est présent, dans la composition de l'invention, en plus des catalyseurs susceptibles d'être déjà présents de façon intrinsèque dans la résine thermodurcissable et/ou dans le durcisseur, du fait de leur préparation pouvant être réalisée en présence de catalyseurs en faible teneur, ou en plus des catalyseurs classiques d'ouverture de cycle époxyde.

Comme catalyseur d'effet vitrimère, on préfère utiliser les composés de type guanidine répondant à la formule (I) : 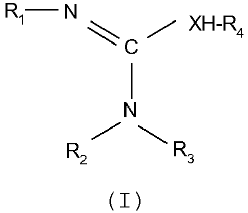 dans laquelle :
X désigne un atome d'azote,
R₁ désigne un atome d'hydrogène, un groupe alkyle en C₁-C₆ ou un groupe phényle pouvant être substitués par un groupe alkyle en C₁-C₄,
R₂, R₃ et R₄ désignent indépendamment un atome d'hydrogène, un groupe alkyle en C₁-C₆, ou un groupe phényle pouvant être substitués par un groupe alkyle en C₁-C₄, ou un groupe acétyle,
ou R₁ et R₂ forment ensemble et avec les atomes auxquels ils sont liés un hétérocycle insaturé et/ou R₃ et R₄ forment ensemble et avec les atomes auxquels ils sont liés un hétérocycle saturé ou insaturé,

On préfère que R₁ et R₂ forment ensemble et avec les atomes auxquels ils sont liés un hétérocycle insaturé, et en ce que R₃ et R₄ forment ensemble et avec les atomes auxquels ils sont liés un hétérocycle saturé ou insaturé, de préférence saturé.

On préfère que les groupes alkyle en C₁-C₆ ou phényle ne soient pas substitués.

Des exemples de catalyseurs de type guanidine utilisables dans la présente invention sont les suivants :

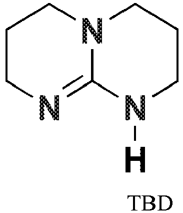

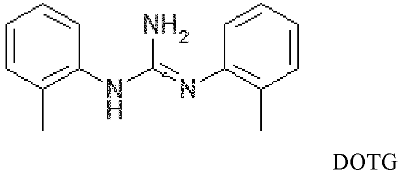

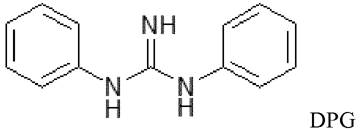

Préférentiellement, le catalyseur de type guanidine est le triazabicyclodécène (TBD).

Selon un mode de réalisation de l'invention, le catalyseur représente de 0,1 à 10% en mol, de préférence de 0,1 à moins de 5% en mol, plus préférentiellement de 0,5 à 2% en mol, relativement à la quantité molaire de fonctions époxy contenues dans ladite résine thermodurcissable.

La composition selon l'invention comprend au moins un durcisseur de résine thermodurcissable, dit "durcisseur acide", qui est de type anhydride d'acide carboxylique, c'est-à-dire comportant au moins une fonction -C(O)-O-C(O)-,

Selon l'invention, on utilise avantageusement un durcisseur de type anhydride d'acide carboxylique. En effet, les réactions époxy-anhydrides sont suffisamment lentes pour permettre la réalisation de pièces massives ou la fabrication de composites par enroulement filamentaire ou pultrusion et elles limitent le dégagement de chaleur lors de la formation de la résine. En outre, les résines époxy-anhydrides ont des taux de retrait très faibles, de sorte qu'elles minimisent les contraintes résiduelles dans les pièces produites et ainsi les risques de rupture. Enfin, leur température de transition vitreuse, qui peut être aisément ajustée, est suffisamment élevée pour garantir la stabilité dimensionnelle des pièces en cours d'usage.

On peut notamment citer comme durcisseurs de type anhydride les anhydrides cycliques, comme par exemple l'anhydride phtalique, l'anhydride nadique ou méthylnadique, l'anhydride dodécénylsuccinique (DDSA), l'anhydride glutarique; les anhydrides aromatiques partiellement ou totalement hydrogénés comme l'anhydride tétrahydrophtalique, ou méthyltétrahydrophtalique, l'anhydride hexahydrophtalique ou méthylhexahydrophtalique; et leurs mélanges.

On peut encore citer comme durcisseurs de type anhydride, l'anhydride succinique, l'anhydride maléique, l'anhydride trimellitique, l'adduit d'anhydride trimellitique et d'éthylèneglycol, l'anhydride chlorendique, l'anhydride tétrachlorophtalique, le dianhydride pyromellitique (PMDA), le dianhydride d'acide 1,2,3,4 cyclopentanetétracarboxylique, les polyanhydrides d'acides aliphatiques tels que le polyanhydride polyazélaique, le polyanhydride polysébacique et leurs mélanges.

On peut notamment utiliser les anhydrides de formules suivantes, et leurs mélanges 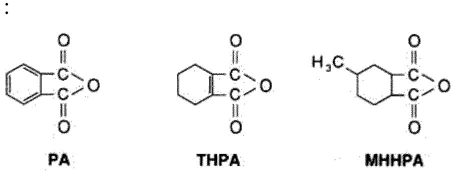 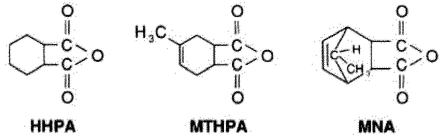 et plus préférentiellement le MTHPA.

On peut encore citer comme durcisseur de type anhydride le durcisseur de référence commerciale HY905 vendu par Huntsman, qui et un mélange liquide de plusieurs anhydrides.

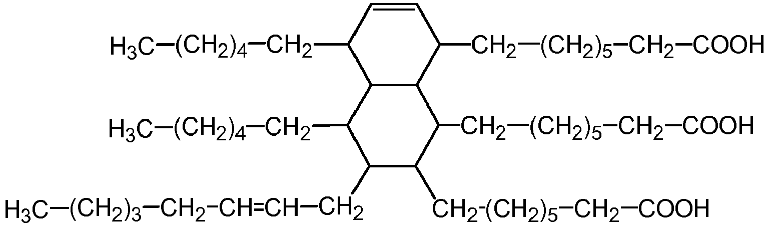

La composition selon l'invention comprend également au moins une résine thermodurcissable comportant au moins une et avantageusement plusieurs fonctions époxyde et optionnellement au moins une et avantageusement plusieurs fonctions hydroxyles libres et/ou fonctions ester. On désignera une telle résine par « résine époxy ».

De façon avantageuse, la résine époxy représente au moins 10 % en poids, au moins 20 % en poids, au moins 40 % en poids, au moins 60 % en poids, voire 100% en poids, du poids total de résine thermodurcissable présente dans la composition.

Il existe deux grandes catégories de résines époxy : les résines époxy de type glycidyle, et les résines époxy de type non glycidyle. Les résines époxy de type glycidyle sont elles-mêmes classées en glycidyle éther, glycidyle ester et glycidyle amine. Les résines époxy non glycidyle sont de type aliphatique ou cycloaliphatique. Les résines époxy glycidyle sont préparées par une réaction de condensation d'un diol, diacide ou diamine avec de l'épichlorhydrine. Les résine époxy non glycidyle sont formées par peroxydation des doubles liaisons oléfiniques d'un polymère.

Parmi les éthers époxy glycidyle, le diglycidyl éther de bisphénol A (DGEBA) représenté ci-dessous est le plus couramment utilisé.

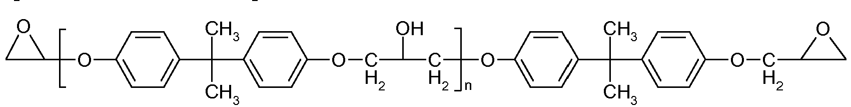

Les résines à base de DGEBA ont d'excellentes propriétés électriques, un faible retrait, une bonne adhérence sur de nombreux métaux et une bonne résistance à l'humidité, aux chocs mécaniques et une bonne résistance thermique.

Les propriétés des résines DGEBA dépendent de la valeur du degré de polymérisation n, qui lui-même dépend de la stoechiométrie de la réaction de synthèse. En règle générale, n varie de 0 à 25.

Les résines époxy Novolac (dont la formule est représentée ci-dessous) sont des glycidyléthers de résines phénoliques novolaques. Elles sont obtenues par réaction du phénol avec le formaldéhyde en présence d'un catalyseur acide pour produire une résine phénolique novolaque, suivie d'une réaction avec l'épichlorhydrine en présence d'hydroxyde de sodium comme catalyseur.

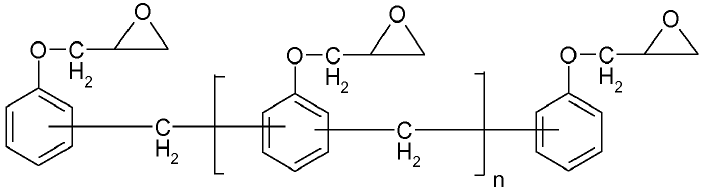

Les résines époxy Novolac contiennent généralement plusieurs groupes époxyde. Les multiples groupes époxyde permettent de réaliser des résines thermodurcies de haute densité de réticulation. Les résines époxy Novolac sont largement utilisées pour fabriquer des matériaux pour la microélectronique en raison de leur résistance supérieure à une température élevée, de leur excellente aptitude au moulage, et de leurs propriétés supérieures mécaniques, électriques, de résistance à la chaleur et à l'humidité.

La résine thermodurcissable utilisable dans la présente invention peut par exemple être choisie parmi : les résines époxy Novolac, le bisphénol A diglycidyl éther (DGEBA), le bisphénol A diglycidyl éther hydrogéné, le bisphénol F diglycidyl éther, le tétraglycidyl méthylène dianiline, le pentaérythritol tétraglycidyl éther, le triméthylol triglycidyl ether (TMPTGE), le tétrabromo bisphénol A diglycidyl éther, ou les hydroquinone diglycidyl éther, l'éthylène glycol diglycidyl éther, le propylène glycol diglycidyl éther, le butylène glycol diglycidyl éther, le néopentyl glycol diglycidyl éther, le 1,4-butanediol diglycidyl éther, le 1,6-hexanediol diglycidyl éther, le cyclohexanediméthanol diglycidyl éther, le polyéthylène glycol diglycidyl éther, le polypropylène glycol diglycidyl éther, le polytétraméthylène glycol diglycidyl éther, le résorcinol diglycidyl éther, le néopentylglycol diglycidyl éther, le bisphénol A polyéthylène glycol diglycidyl éther, le bisphénol A polypropylèneglycol diglycidyl éther, le diglycidyl ester d'acide téréphtalique, le poly(glycidyle-acrylate), le poly(glycidyle-méthacrylate), les acides gras polyinsaturés époxydés, les huiles végétales époxydées notamment l'huile de soja époxydée, les huiles de poissons époxydées, et le limonène époxydé; les glycidyl esters de l'acide versatique tels que ceux commercialisés sous la dénomination CARDURA® E8, E10 ou E12 par la société Momentive (CARDURA® E10 de CAS 26761-45-5) ; les résines cycloaliphatiques époxydées commercialisées sous la dénomination ARALDITE® CY179, CY184, MY0510 et MY720 par la société BASF, les résines CY179 et la CY184 répondant respectivement aux formules suivantes : 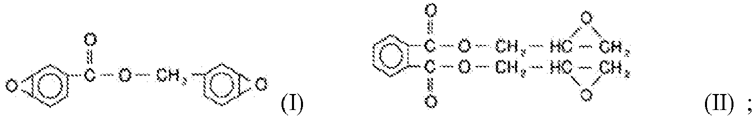 le triglycidyl isocyanurate (TGIC) ; le glycidyl méthacrylate, les glycidyl (méth)acrylates alkoxylés ; les C8-C10 alkyl glycidyl éthers, les C12-C14 alkyl glycidyl ethers, le glycidyl ester d'acide néodecanoïque, le butyl glycidyl éther, le crésyl glycidyl éther, le phényl glycidyl éther, le p-nonyphényl glycidyl éther, le p-nonylphényl glycidyl éther, le p-t-butyl phényl glycidyl éther, le 2-éthylhexyl glycidyl éther, le néopentyl glycol diglycidyl éther, le diglycidyl ester de dimère d'acide, le cyclohexane diméthanol diglycidyl éther, le polyglycidyl éther d'huile de riçin ; et les mélanges des résines précitées.

Avantageusement, elle est plus particulièrement choisie parmi : le DGEBA, le bisphénol F diglycidyl éther, les résines Novolac, le TMPTGE, le 1,4-butanediol diglycidyl éther, l'ARALDITE®CY184 de formule (II) ci-dessus, le TGIC, l'huile de soja époxydée et leurs mélanges. Plus préférentiellement encore, il s'agit du DGEBA.

Selon un mode de réalisation, la composition est constituée par le catalyseur d'effet vitrimère, le durcisseur et une résine thermodurcissable époxy, tels que définis plus haut. Selon ce mode de réalisation, le nombre de moles de catalyseur peut aller de 0,1 à 10 %, de préférence de 0,5 à 5%, de préférence de 0,5 à 2 %, relativement au nombre de moles de fonctions anhydride du durcisseur. Le nombre de moles de fonctions époxydes de la résine peut aller de 50 à 300%, de préférence de 100% à 200%, de préférence de 125 à 150 %, relativement au nombre de moles de fonctions anhydride du durcisseur.

La composition de l'invention peut éventuellement comprendre un ou plusieurs composés additionnels, dans la mesure où leur présence n'altère pas les propriétés avantageuses qui découlent de l'invention. Des exemples de tels composés additionnels sont : des polymères, des pigments, des colorants, des charges isolantes, des plastifiants, des fibres longues ou courtes, tissées ou non, des agents retardateurs de flamme, des agents antioxydants, des lubrifiants, du bois, du verre, des métaux et leurs mélanges.

Avantageusement, la teneur en résine thermodurcissable et en durcisseur va de 10% à 90 % en poids, notamment de 20 % à 80 % en poids voire de 30 à 70 % en poids, relativement au poids total de la composition, le complément à 100 % étant apporté par le catalyseur et éventuellement par des composés additionnels choisis parmi les composés précités.

Parmi les polymères qui peuvent être employés en mélange avec la composition de l'invention, on peut mentionner : des élastomères, des thermoplastiques, des élastomères thermoplastiques, des additifs chocs.

Par pigments, on entend des particules colorées insolubles dans la composition de l'invention. Comme pigments utilisables selon l'invention, on peut citer les phtalocyanines, les anthraquinones, les quinacridones, les dioxazines, les pigments azoïques ou tout autre pigment organique, les pigments naturels (garance, indigo, pourpre, cochenille, etc) et les mélanges de pigments.

Par colorants, on entend des molécules solubles dans la composition de l'invention et ayant la capacité d'absorber une partie du rayonnement visible.

Comme exemple de charges isolantes pouvant être incluses dans la composition, on peut citer celles choisies parmi : les oxydes inorganiques, les hydroxydes inorganiques et les oxyhydroxydes inorganiques, telles que la silice, le quartz, les silicates tels que les argiles, le talc et le kaolin, l'alumine ou l'oxyde de titane ; le carbonate de calcium ; les nitrures tels que le nitrure de silicium, le nitrure de bore et le nitrure d'aluminium ; les carbures tels que le carbure de silicium ; les whiskers ; et leurs mélanges.

Ces charges peuvent représenter de 5 à 80% en poids, de préférence de 10 à 60% en poids et plus préférentiellement de 20 à 50% en poids, voire de 20 à 40% par rapport au poids total de la composition.

Parmi les fibres qui peuvent être employées dans la composition de l'invention, on peut mentionner : des fibres de verre, des fibres de carbone, des fibres polyester, des fibres polyamides, des fibres aramides, des fibres cellulosiques et nanocellulosiques ou encore des fibres végétales (lin, chanvre, sisal, bambou...) et leurs mélanges.

La présence, dans la composition de l'invention, de pigments, de colorants ou de fibres capables d'absorber le rayonnement, ou leurs mélanges, peut servir à assurer le chauffage d'un matériau ou d'un objet fabriqué à partir d'une telle composition, au moyen d'une source de rayonnement telle qu'un laser.

Les composés additionnels peuvent aussi être choisis parmi un ou plusieurs autres catalyseurs et/ou durcisseurs, de toutes natures connues de l'homme du métier comme jouant ces rôles dans la mesure ou ils n'altèrent pas les propriétés avantageuses découlant de l'invention. Ils seront désignés par « catalyseur supplémentaire » et « durcisseur supplémentaire ».

Selon une forme d'exécution préférée de l'invention, la composition décrite ici renferme en outre un ou plusieurs catalyseurs supplémentaires qui sont spécifiques de l'ouverture d'époxyde, tels que :
- les amines tertiaires, éventuellement bloquées, comme par exemple: le 2,4,6-tris(diméthylaminométhyl)phénol (par exemple commercialisée sous le nom Ancamine), o-(diméthylaminométhyl) phénol, la benzyldiméthylamine (BDMA), le 1,4-diazabicyclo(2,2,2)octane (DABCO), le chlorure de méthyltribenzyl ammonium.
- les imidazoles, comme les 2-méthylimidazole (2-MI), 2-phénylimidazole (2-PI), 2-éthyl-4-méthyl-imidazole (EMI), 1-propylimidazole, chlorure de 1-éthyl-3-méthylimidazolium, 1-(2-hydroxypropyl)imidazole.
- les phosphoniums : les halogénures de tetraalkyl et alkyltriphénylphosphonium.
- les sels d'amine de polyacides, les condensats aniline-formaldéhyde, les N,N-alcanolamines, les borates de trialcanolamines, les fluoroborates comme la monoéthylamine de trifluorure de bore (BF3-MEA), les phosphines organosubstituées, les sels de monoimidazoline quaternaire, des mercaptans, des polysulfures.
- et leurs mélanges.

Préférentiellement, le catalyseur d'ouverture d'époxyde est choisi parmi : les amines tertiaires, les imidazoles, et leurs mélanges.

Les amines (hétéro)aromatiques telles que la 2-méthylimidazole et le tris(diméthylaminométhyl)phénol sont plus particulièrement préférées pour une utilisation dans cette invention.

Ce catalyseur supplémentaire d'ouverture d'époxyde est avantageusement mis en oeuvre dans la composition à raison de 0,1% à 5% molaire par rapport au nombre de moles de fonctions époxydes portées par la résine thermodurcissable.

On peut aussi mettre en oeuvre un ou plusieurs catalyseurs supplémentaires d'effet vitrimère choisis parmi les catalyseurs cités dans les demandes WO2011/151584, WO2012/101078 et WO 2012/152859, toujours dans la mesure ou leur présence n'altère pas les propriétés avantageuses découlant de l'invention.

Le catalyseur supplémentaire d'effet vitrimère peut par exemple être présent dans la composition de l'invention à raison de 0,1 à 10 % en poids et de préférence de 0,1 à 5 % en poids relativement au poids total de la composition.

Par ailleurs, l'utilisation d'un durcisseur supplémentaire permet d'obtenir, pour les matériaux fabriqués *in fine,* une large gamme de propriétés mécaniques à la température ambiante (par exemple contrôle de la température de transition vitreuse et/ou du module d'une résine thermodurcie).

Comme exemples de durcisseurs supplémentaires, on peut mentionner les durcisseurs de résine époxy, en particulier ceux choisis parmi les aminés, les polyamides, les résines phénoliques, les isocyanates, les polymercaptans, les dicyanodiamides et leurs mélanges.

En particulier, un durcisseur supplémentaire de type amine peut être choisi parmi les amines primaires ou secondaires ayant au moins une fonction -NH₂ ou deux fonctions -NH et de 2 à 40 atomes de carbone. Ces amines peuvent par exemple être choisies parmi les amines aliphatiques telles que la diéthylène triamine, la triéthylène tétramine, la tétraéthylène pentamine, la dihexylène triamine, la cadavérine, la putrescine, l'hexanediamine, la spermine, l'isophorone diamine, ainsi que les amines aromatiques telles que la phénylène diamine, le diamino diphénylméthane, la diamino diphénylsulfone, la méthylène bischlorodiéthylaniline, la meta-xylylène diamine (MXDA) et ses dérivés hydrogénés tels que le 1,3-bis(aminométhyl cyclohexane) (1,3-BAC) ; et leurs mélanges.

Un durcisseur supplémentaire de type amine peut encore être choisi parmi les polyétheramines, par exemple les JEFFAMINES de Huntsman, éventuellement en mélanges avec d'autres durcisseurs supplémentaires.

Comme durcisseurs supplémentaires préférés, on peut citer la diéthylène triamine, la triéthylène tétramine, l'hexanediamine, et leurs mélanges.

Selon une forme d'exécution préférée de l'invention, la composition décrite ici renferme en outre au moins un polyol, en particulier un polyhydroxyalcane linéaire ou ramifié, tel que le glycérol, le triméthylolpropane ou le pentaérythritol. D'autres types de polyols sont également utilisables. Il a en effet été observé que l'ajout de ce composé au mélange réactionnel permettait d'améliorer encore les propriétés vitrimères du matériau, c'est-à-dire d'obtenir un matériau capable de relaxer plus complètement et plus rapidement les contraintes après application d'une déformation.

### Procédé de préparation de la composition

Les composés de la composition utilisée selon l'invention sont soit disponibles commercialement, soit facilement synthétisables par l'homme du métier à partir de matières premières disponibles commercialement.

Cette composition peut être obtenue par simple mise en contact des composés qu'elle renferme. Cette mise en contact est de préférence effectuée à une température allant de 15°C à 130°C, notamment de 50°C à 125°C. La mise en contact peut être effectuée avec ou sans moyen d'homogénéisation.

Selon un mode de réalisation particulier, le procédé comprend une première étape au cours de laquelle le catalyseur est préintroduit dans la résine ou le durcisseur, de préférence dans le durcisseur. Le catalyseur peut être alors sous forme de dispersion s'il s'agit d'une poudre, ou d'une solution. Cette dispersion ou mise en solution peut être effectuée à température ambiante ou à chaud pour obtenir les caractéristiques de viscosité souhaitées.

La composition utilisée selon l'invention peut être préparée à partir d'un kit comportant au moins :
- une première composition comprenant le catalyseur, seul, ou avec le durcisseur ou la résine thermodurcissable ;
- éventuellement une deuxième composition comprenant le durcisseur
- éventuellement une troisième composition comprenant la résine thermodurcissable.

Les différentes compositions peuvent être stockées ensemble ou séparément. Il est aussi possible de stocker ensemble certaines des compositions tout en les maintenant séparées des autres compositions.

Les différentes compositions sont stockées généralement à température ambiante.

De préférence, lorsque les deuxième et troisième compositions sont toutes deux présentes dans le kit, elles sont dans un conditionnement adapté pour empêcher qu'une réaction de réticulation entre la résine thermodurcissable et le durcisseur ne se produise sans intervention d'un opérateur.

Le conditionnement peut consister en un récipient comportant deux voire trois compartiments internes permettant le stockage séparé de chacune des compositions. Selon une variante, le kit peut consister en un seul et unique récipient, contenant un mélange en quantités appropriées des deux ou trois compositions. Dans ce dernier cas, l'intervention de l'opérateur se limite avantageusement à un chauffage.

Il peut être prévu un moyen permettant la mise en contact des contenus des différents compartiments, avantageusement de façon à permettre d'initier la réticulation dans le récipient.

On peut aussi prévoir un kit consistant en plusieurs flacons distincts associés dans un même emballage et comportant chacun les quantités adaptées de chacune des compositions pour la préparation de la composition de l'invention, de façon à éviter à l'utilisateur des opérations de pesée et/ou de dosage.

### Utilisations

Selon l'invention, 1a composition décrite précédemment est utilisée pour la fabrication de pièces d'isolation électrique choisies parmi : un isolateur électrique de composants électriques ou électroniques, sous forme moulée ou sous forme de matrice, de revêtement, de joint ou d'adhésif, et notamment un adhésif pour tableaux de connexion imprimés, une résine matricielle pour pré-imprégnés, ou une résine de revêtement ou d'encapsulation de transistors, de diodes, de transformateurs ou de circuits intégrés.

Les pièces d'isolation électrique peuvent être fabriquées par un procédé classique de mise en oeuvre de résines époxy, comme par exemple le moulage, le Resin Transfert Moulding (RTM), l'enroulement filamentaire, la pultrusion. Dans ces cas les pièces obtenues sont ensuite assemblées dans des systèmes plus complexes d'isolateurs et/ou mis en contact des composants conducteurs. Habituellement pour les applications électriques la formulation vitrimère comprend des charges de type silice, argile. Elle est également très souvent utilisée pour obtenir des matériaux composites à base par exemple de fibres de verre, avec un des procédés cités ci-dessus.

Un autre mode d'obtention de systèmes isolants électriquement consiste à noyer un système électrique ou électronique dans la formulation thermodurcissable de type vitrimère, par les procédés utilisés classiquement pour ce type d'opération : moulage par gravité, moulage par injection basse pression, enrobage (« potting »).

Le procédé de fabrication de ces pièces d'isolation comprend alors les étapes suivantes :
a) la préparation à chaud d'une composition renfermant une résine thermodurcissable de type époxy, un durcisseur et au moins un catalyseur organique non métallique d'effet vitrimère, à partir de la composition décrite précédemment,
b) éventuellement, la mise en contact de la composition issue de l'étape (a) avec au moins un élément électriquement conducteur,
c) la mise en forme de la composition issue de l'étape a),
d) l'application d'une énergie permettant le durcissement de la résine,
e) le refroidissement de la résine thermodurcie.

Cette résine thermodurcie présente avantageusement :
- une température de transition vitreuse (Tg) comprise entre 50 et 170°C, de préférence entre 70 et 160°C, plus préférentiellement entre 100 et 150°C,
- un temps de relaxation τ nécessaire pour obtenir une valeur de contrainte normalisée égale à 1/e à une température égale à Tg + 100°C et/ou à 200°C, qui est inférieur à 5000 secondes, de préférence inférieur à 2000 secondes, plus préférentiellement inférieur à 1000 secondes,
- un pourcentage de contraintes **σ** relaxées au bout de 5000 secondes à une température égale à Tg + 100°C et/ou à 200°C, qui est d'au moins 80%, de préférence d'au moins 90%, plus préférentiellement d'au moins 95%, voire de 100%,
- un module de conservation (G') au plateau caoutchoutique, par exemple à une température comprise entre 150 et 200°C, supérieur à 5 MPa, de préférence supérieur ou égal à 10 MPa, voire supérieur ou égal à 15 MPa.

Ces grandeurs sont mesurées suivant les protocoles indiqués dans les exemples ci-après. Les caractéristiques de la résine thermodurcie sont particulièrement bien adaptées au cahier des charges des pièces d'isolation électrique.

### Procédé de déformation ou de réparation

Les résines thermodurcies obtenues comme décrit précédemment présentent l'avantage de présenter une variation lente de viscosité sur une large gamme de températures, ce qui rend le comportement des pièces d'isolation obtenues à partir de ces résines comparable à celui des verres inorganiques et permet de leur appliquer des procédés de déformation qui ne sont pas applicables aux thermodurs classiques.

Ces pièces peuvent ainsi être façonnées en appliquant des contraintes de l'ordre de 1 à 10 MPa sans pour autant couler sous leur propre poids.

De la même façon, on peut déformer ces pièces à une température supérieure à la température Tg, puis dans un deuxième temps éliminer les contraintes internes à une température plus élevée.

L'application de chaleur peut permettre également de réparer des fissures par la remise en contact des surfaces séparées sous l'effet d'une pression.

Il faut noter qu'aucune dépolymérisation n'est constatée à des températures élevées et les pièces d'isolation de l'invention conservent leur structure réticulée. Cette propriété permet la réparation de pièces qui se trouveraient fissurées voire fracturées en au moins deux parties par un simple soudage de ces parties entre elles. Aucun moule n'est nécessaire pour maintenir la forme des pièces de l'invention pendant le processus de réparation à des températures élevées.

Ainsi, les pièces d'isolation telles que décrites plus haut peuvent être déformées suivant un procédé comprenant l'application à celles-ci d'une contrainte mécanique à une température (T) supérieure à la température de transition vitreuse. L'assemblage, le soudage, la réparation et le recyclage constituent un cas particulier de ce procédé de déformation. De préférence, pour permettre la déformation dans une durée compatible avec une application industrielle, le procédé de déformation comprend l'application aux pièces d'isolation de l'invention d'une contrainte mécanique à une température (T) supérieure à la température de transition vitreuse Tg de la résine thermodurcie qu'elles contiennent.

Habituellement, un tel procédé de déformation est suivi d'une étape de refroidissement jusqu'à la température ambiante, éventuellement avec application d'au moins une contrainte mécanique. Par « contrainte mécanique », on entend au sens de la présente invention, l'application d'une force mécanique, localement ou sur tout ou partie de la pièce, cette force mécanique tendant à une mise en forme ou une déformation de la pièce. Parmi les contraintes mécaniques qui peuvent être employées, on peut mentionner : la pression, le moulage, le malaxage, l'extrusion, le soufflage, l'injection, l'estampage, la torsion, la flexion, la traction et le cisaillement. Il peut s'agir par exemple d'une torsion appliquée à la pièce de l'invention sous forme de ruban. Il peut s'agir d'une pression appliquée à l'aide d'une plaque ou d'un moule sur une ou plusieurs faces d'une pièce de l'invention, de l'estampage d'un motif dans une plaque ou une feuille. Il peut encore s'agir d'une pression exercée parallèlement sur deux pièces de l'invention en contact l'une avec l'autre de façon à provoquer un soudage de ces pièces. La contrainte mécanique peut également consister en une multiplicité de contraintes distinctes, de même nature ou non, appliquées de façon simultanée ou successive à tout ou partie des pièces de l'invention, ou de façon localisée.

Ce procédé de déformation peut inclure une étape de mélange ou d'agglomération de la pièce d'isolation de l'invention avec un ou plusieurs composants additionnels choisis parmi ceux cités précédemment et en particulier : des polymères, des pigments, des colorants, des charges, des plastifiants, des fibres longues ou courtes, tissées ou non, des agents retardateurs de flamme, des agents antioxydants, des lubrifiants.

L'élévation de la température dans le procédé de déformation peut être réalisée par tout moyen connu comme le chauffage par conduction, convection, induction, par point, infra rouge, micro-onde ou radiant. Les moyens permettant de provoquer une élévation de température pour la mise en oeuvre des procédés de l'invention comprennent : un four, un four à micro-ondes, une résistance chauffante, une flamme, une réaction chimique exothermique, un faisceau laser, un fer à repasser, un pistolet à air chaud, une cuve à ultrasons, un poinçon chauffant... L'élévation de température peut être faite par pallier ou non et sa durée est adaptée au résultat attendu.

Bien que la résine ne coule pas durant sa déformation, grâce aux réactions d'échange interne, en choisissant une température, une durée de chauffage et des conditions de refroidissement appropriées, la nouvelle forme peut être exempte de toute contrainte résiduelle. La pièce n'est donc pas fragilisée ou fracturée par l'application de la contrainte mécanique. Et si la pièce déformée est ultérieurement réchauffée, elle ne reviendra pas à sa forme première. En effet, les réactions d'échange interne qui surviennent à haute température favorisent une réorganisation des points de réticulation du réseau de la résine thermodurcie de manière à annuler les contraintes mécaniques. Une durée de chauffage suffisante permet d'annuler complètement ces contraintes mécaniques internes à la pièce qui ont été causées par l'application de la contrainte mécanique externe.

Cette méthode permet donc d'obtenir des formes complexes stables, difficiles voire impossibles à obtenir par moulage, à partir de formes élémentaires plus simples. Notamment, il est très difficile d'obtenir par moulage des formes résultant d'une torsion. De façon complémentaire, le choix de conditions de température, de durée de chauffage sous contrainte et de refroidissement appropriées permet de transformer une pièce selon l'invention tout en contrôlant la persistance de certaines contraintes mécaniques internes au sein de cette pièce, puis, si la pièce ainsi transformée est ultérieurement réchauffée, une nouvelle déformation contrôlée de cette pièce par libération contrôlée des contraintes peut être opérée.

### Procédés de recyclage

La pièce d'isolation obtenue selon l'invention peut également être recyclée :
- soit par traitement direct : par exemple une pièce de l'invention cassée ou endommagée est réparée par un procédé de déformation tel que décrit ci-dessus et peut ainsi retrouver sa fonction d'usage antérieure ou une autre fonction ;
- soit la pièce est réduite en particules par application d'un broyage mécanique, et les particules ainsi obtenues sont ensuite mises en oeuvre dans un procédé de fabrication d'une pièce d'isolation conforme à l'invention. Notamment, selon ce procédé, les particules sont soumises simultanément à une élévation de température et à une contrainte mécanique permettant leur transformation en une pièce d'isolation conforme à l'invention.

La contrainte mécanique permettant la transformation des particules peut par exemple comporter une compression dans un moule, un malaxage, et/ou une extrusion. Cette méthode permet notamment, par l'application d'une température suffisante et d'une contrainte mécanique appropriée, de mouler de nouvelles pièces.

### EXEMPLES

Les exemples suivants illustrent l'invention sans la limiter.

### Exemple 1 : Synthèse d'un réseau époxy-anhydride en présence de 1% de TBD

On a préparé plusieurs échantillons de matériau vitrimère comme décrit ci-dessous.
Dans un bêcher ont été ajoutés une résine époxy de type DGEBA (DER332 de DOW, Masse Epoxy Equivalente : 174g/eq) sous forme de liquide visqueux, ainsi que du TBD (ALDRICH) à raison de 1% molaire de catalyseur par mole de fonctions époxyde. Le bécher a été placé dans un bain d'huile thermostaté à 100-120°C jusqu'à dissolution du catalyseur dans la résine pour obtenir un mélange homogène et transparent. On a alors ajouté à ce mélange, hors du bain, de l'anhydride méthyl tétrahydrophthalique (MTHPA) (MW = 166,18g/mol) puis l'ensemble a été homogénéisé quelques minutes dans le bain avant d'être coulé dans un moule métallique creux de 70x140x3mm légèrement siliconé. Le moule a été solidarisé par un joint en silicone à une plaque métallique recouverte d'un revêtement en Teflon, puis l'ensemble a été introduit dans une presse chauffante préalablement réglée à une température de 140°C et placée en début de cuisson à une pression de 10 bars. La cuisson a été effectuée pendant 17 heures.

Le procédé ci-dessus a été mis en oeuvre en utilisant différents ratios molaires des fonctions époxyde de la résine aux fonctions anhydride du durcisseur, à savoir :
- un ratio de 1/0,5 pour l'échantillon 1a,
- un ratio de 1/0,8 pour l'échantillon 1b,
- un ratio de 1/1 pour l'échantillon 1c.

### Exemple 2 : Propriétés mécaniques

On a évalué les propriétés mécaniques des matériaux de l'Exemple 1, ainsi que d'un matériau obtenu de manière identique à l'échantillon 1b, excepté que le TBD a été remplacé par un catalyseur d'ouverture d'époxyde sous forme d'amine tertiaire, qui est classiquement utilisé pour la synthèse de résines époxy-anhydride, le 1,4-diaza-bicyclooctane (DABCO). Cet échantillon comparatif sera désigné par la suite par "échantillon 2".

Précisément, des échantillons de ces matériaux ont d'abord été soumis à une analyse mécanique dynamique (DMA). Pour ce faire, un barreau de dimensions 10x30x3mm a été fixé entre deux pinces et sollicité en torsion rectangulaire (déformation imposée de 0,05%) dans un appareil RDA3 de RHEOMETRIC SCIENTIFIC, avec une fréquence de 1 Hz, en effectuant un balayage en température de 25 à 250°C avec une rampe de température de 3°C/min. La valeur de Tα a été déterminée au sommet du pic de la courbe de tan8, et est considérée ci-après comme la Tg de l'échantillon, tandis que le module de conservation G' a été déterminé sur le plateau caoutchoutique à 200°C.
On a ainsi obtenu les valeurs indiquées dans le Tableau 1 ci-dessous.

**Tableau 1**

| Ech. | 1a | 1b | 1c | 2 (comp) |
|---|---|---|---|---|
| Tg (°C) | 130 | 148 | 148 | 110 |
| G' (MPa) | 15 | 14 | 15 | 7 |

Un autre échantillon de chacun de ces matériaux a en outre été soumis à une expérience consistant à imposer à une éprouvette de 40x20x2mm une déformation sous flux d'azote, en flexion 3 points, à l'aide d'un appareil Metravib de type DMA50N, après que l'échantillon ait été porté à une température égale à Tg + 100°C ou à 200°C, et stabilisé pendant 5 min à cette température. L'évolution des contraintes induites dans le matériau pour maintenir la déformation constante est suivie pendant 5000 secondes et mesurée à l'aide d'un capteur. On impose ensuite à l'échantillon une force égale à zéro et on mesure la déformation (recouvrance) de l'échantillon pendant 5000 secondes supplémentaires. Lorsque le matériau conserve la déformation qui lui a été imposée, on considère que toutes les contraintes ont été relaxées. On trace ensuite la contrainte normalisée (σ/σο) en fonction du temps et on relève, pour chaque essai, le temps de relaxation τ nécessaire pour obtenir une valeur de contrainte normalisée égale à 1/e, ainsi que le pourcentage de contraintes relaxées à 5000 secondes, désigné ci-après par σ_{5000s.}

Les résultats obtenus sont rassemblés dans le Tableau 2 ci-dessous.

**Tableau 2**

| Ech. | 1a | 1b | 1c | 2 (comp) |
|---|---|---|---|---|
| τ (s) | 345 | 1015 | 1655 | > 5000 |
| σ₅₀₀₀ₛ (%) | 96 | 100 | 100 | 28 |

Comme il ressort de ce tableau, la composition selon l'invention permet d'obtenir des matériaux capables de relaxer leurs contraintes de manière complète et rapide, contrairement au matériau comparatif obtenu sans catalyseur d'effet vitrimère. Il s'ensuit que seuls les matériaux obtenus selon l'invention présentent des propriétés vitrimères leur permettant d'être réparés par simple chauffage.

### Exemple 3: Stabilité thermique

On a évalué la stabilité thermique du matériau 1a de l'Exemple 1. La mesure a été effectuée par ATG sur un appareil Perkin Elmer de type TGA7, en effectuant un balayage de températures de 25°C à 500°C suivant une rampe de 10°C/min. La température conduisant à une perte de matière de 1% était de 305°C. En outre, la perte de matériau après 1h à 250°C s'élevait à 1,5% seulement. Ces résultats reflètent la bonne tenue thermique des matériaux selon l'invention aux températures de réparation et de recyclage.

## Revendications

1. Utilisation d'une composition renfermant, outre une résine thermodurcissable de type époxy et un durcisseur choisi parmi les anhydrides d'acide carboxylique comportant au moins une fonction -C(O)-O-C(O)-, au moins un catalyseur organique non métallique d'effet vitrimère à une teneur allant de 0,1 à 10% en mol, relativement à la quantité molaire de fonctions époxy contenues dans la résine thermodurcissable, ledit catalyseur étant choisi parmi les composés de type guanidine répondant à la formule (I) : 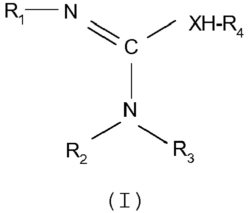 dans laquelle :
X désigne un atome d'azote,
R₁ désigne un atome d'hydrogène, un groupe alkyle en C₁-C₆ ou un groupe phényle pouvant être substitués par un groupe alkyle en C₁-C₄,
R₂, R₃ et R₄ désignent indépendamment un atome d'hydrogène, un groupe alkyle en C₁-C₆, ou un groupe phényle pouvant être substitués par un groupe alkyle en C₁-C₄, ou un groupe acétyle,
ou R₁ et R₂ forment ensemble et avec les atomes auxquels ils sont liés un hétérocycle insaturé et/ou R₃ et R₄ forment ensemble et avec les atomes auxquels ils sont liés un hétérocycle saturé ou insaturé ;
pour la fabrication de pièces d'isolation électrique choisies parmi : un isolateur électrique de composants électriques ou électroniques, sous forme moulée ou sous forme de matrice, de revêtement, de joint ou d'adhésif, et notamment un adhésif pour tableaux de connexion imprimés, une résine matricielle pour pré-imprégnés, ou une résine de revêtement ou d'encapsulation de transistors, de diodes, de transformateurs ou de circuits intégrés.

2. Utilisation selon la revendication 1, **caractérisée en ce que** la résine thermodurcissable est un diglycidyl éther de bisphénol A (DGEBA).

3. Utilisation selon l'une des revendications 1 et 2, **caractérisée en ce que** le durcisseur est choisi parmi les anhydrides cycliques, comme l'anhydride phtalique, l'anhydride nadique ou méthylnadique, l'anhydride dodécénylsuccinique (DDSA), l'anhydride glutarique ; les anhydrides aromatiques partiellement ou totalement hydrogénés comme l'anhydride tétrahydrophtalique, ou méthyltétrahydrophtalique, l'anhydride hexahydrophtalique ou méthylhexahydrophtalique; les anhydrides tels que l'anhydride succinique, l'anhydride maléique, l'anhydride trimellitique, l'adduit d'anhydride trimellitique et d'éthylèneglycol, l'anhydride chlorendique, l'anhydride tétrachlorophtalique, le dianhydride pyromellitique (PMDA), le dianhydride d'acide 1,2,3,4 cyclopentanetétracarboxylique ; les polyanhydrides d'acides aliphatiques tels que le polyanhydride polyazélaique, le polyanhydride polysébacique, et leurs mélanges.

4. Utilisation selon l'une quelconque des revendications précédentes, **caractérisée en ce que** le catalyseur d'effet vitrimère est choisi parmi les composés triazobicyclodécène (TBD), diorthotoluidineguanidine (DOTG) ou 1,3- diphénylguanidine (DPG), de préférence le catalyseur est le triazobicyclodécène (TBD).

5. Utilisation selon l'une quelconque des revendications précédentes, **caractérisée en ce que** le catalyseur représente de 0,1 à moins de 5% en mol, plus préférentiellement de 0,5 à 2% en mol, relativement à la quantité molaire de fonctions époxy contenues dans ladite résine thermodurcissable.

6. Utilisation selon l'une quelconque des revendications précédentes, **caractérisée en ce que** la composition renferme en outre au moins une charge choisie parmi : les oxydes inorganiques, les hydroxydes inorganiques et les oxyhydroxydes inorganiques, telles que la silice, le quartz, les silicates tels que les argiles, le talc et le kaolin, l'alumine ou l'oxyde de titane ; le carbonate de calcium ; les nitrures tels que le nitrure de silicium, le nitrure de bore et le nitrure d'aluminium ; les carbures tels que le carbure de silicium ; les whiskers ; et leurs mélanges.

7. Utilisation selon la revendication 6, **caractérisée en ce que** les charges représentent de 5 à 80% en poids, de préférence de 10 à 60% en poids et plus préférentiellement de 20 à 50% en poids, par rapport au poids total de la composition.

8. Procédé de fabrication de pièces d'isolation électrique, comprenant :
a) la préparation à chaud d'une composition renfermant une résine thermodurcissable de type époxy, un durcisseur et au moins un catalyseur organique non métallique d'effet vitrimère à partir de la composition telle que définie dans l'une quelconque des revendications 1 à 7,
b) éventuellement, la mise en contact de la composition issue de l'étape (a) avec au moins un élément électriquement conducteur,
c) la mise en forme de la composition issue de l'étape a),
d) l'application d'une énergie permettant le durcissement de la résine,
e) le refroidissement de la résine thermodurcie.

9. Pièce d'isolation électrique obtenue suivant le procédé selon la revendication 8.

## Patentansprüche

1. Verwendung einer Zusammensetzung, die außer einem wärmehärtbaren Epoxidharz und einem Härtungsmittel, das aus Carboxylsäureanhydriden mit mindestens einer Funktion -C(O)-O-C(O)- ausgewählt ist, mindestens einen organischen nichtmetallischen Katalysator mit Vitrimerwirkung mit einem Gehalt von 0,1 bis 10 Mol-%, bezogen auf die molare Menge der Epoxidfunktionen im wärmehärtbaren Harz, umfasst, wobei der Katalysator aus den Guanidinverbindungen mit folgender Formel (I) ausgewählt ist: 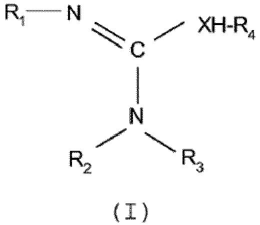 wobei:
X ein Stickstoffatom bezeichnet,
R₁ ein Wasserstoffatom, eine C₁-C₆-Alkylgruppe oder eine Phenylgruppe bezeichnet, die durch eine C₁-C₄-Alkylgruppe substituiert sein können,
R₂, R₃ und R₄ unabhängig voneinander ein Wasserstoffatom, eine C₁-C₆-Alkylgruppe oder eine Phenylgruppe bezeichnen, die durch eine C₁-C₄-Alkylgruppe oder eine Acetylgruppe substituiert sein können,
oder R₁ und R₂ zusammen und mit den Atomen, mit denen sie verbunden sind, einen ungesättigten Heterocyclus bilden, und/oder R₃ und R₄ zusammen und mit den Atomen, mit denen sie verbunden sind, einen gesättigten oder ungesättigten Heterocyclus bilden;
zur Herstellung von elektrisch isolierenden Teilen, die ausgewählt sind aus: einem elektrischen Isolator von elektrischen oder elektronischen Komponenten als Formkörper oder in Form einer Matrix, einer Beschichtung, einer Dichtung oder eines Klebstoffs und insbesondere eines Klebstoffs für Leiterplatten, einem Matrixharz für Prepregs oder einem Harz zum Beschichten oder Verkapseln von Transistoren, Dioden, Transformatoren oder integrierten Schaltungen.

2. Verwendung nach Anspruch 1, **dadurch gekennzeichnet, dass** es sich beim wärmehärtbaren Harz um Bisphenol-A-diglycidylether (DGEBA) handelt.

3. Verwendung nach einem der Ansprüche 1 und 2, **dadurch gekennzeichnet, dass** das Härtungsmittel ausgewählt ist aus zyklischen Anhydriden, wie Phthalsäureanhydrid, Nadicanhydrid oder Methylnadicanhydrid, Dodecenylbernsteinsäureanhydrid (DDSA), Glutarsäureanhydrid; teilweise oder vollständig hydrierten aromatischen Anhydriden, wie Tetrahydrophthalsäure- oder Methyltetrahydrophthalsäureanhydrid, Hexahydrophthalsäure- oder Methylhexahydrophthalsäureanhydrid; Anhydriden, wie Bernsteinsäureanhydrid, Maleinsäureanhydrid, Trimellithsäureanhydrid, dem Addukt von Trimellithsäureanhydrid und Ethylenglycol, Chlorendicanhydrid, Tetrachlorphthalsäureanhydrid, Pyromellitsäuredianhydrid (PMDA), 1,2,3,4-Cyclopentan-Tetracarboxylsäure-Dianhydrid; Polyanhydriden von aliphatischen Säuren, wie Polyazelainsäurepolyanhydrid, Polysebacinsäurepolyanhydrid und Mischungen davon.

4. Verwendung nach einem der vorhergehenden Ansprüche, **dadurch gekennzeichnet, dass** der Katalysator mit Vitrimerwirkung aus den Verbindungen Triazobicyclodecen (TBD), Diorthotoluidinguanidin (DOTG) oder 1,3-Diphenylguanidin (DPG) ausgewählt ist, wobei der Katalysator vorzugsweise Triazobicyclodecen (TBD) ist.

5. Verwendung nach einem der vorhergehenden Ansprüche, **dadurch gekennzeichnet, dass** der Katalysator von 0,1 bis weniger als 5 Mol-%, noch mehr bevorzugt von 0,5 bis 2 Mol-%, bezogen auf die molare Menge der Epoxidfunktionen im wärmehärtbaren Harz, darstellt.

6. Verwendung nach einem der vorhergehenden Ansprüche, **dadurch gekennzeichnet, dass** die Zusammensetzung außerdem mindestens ein Füllmittel umfasst, das ausgewählt ist aus:
anorganischen Oxiden, anorganischen Hydroxiden und anorganischen Oxyhydroxiden, wie Siliciumdioxid, Quarz, Silikaten, wie Ton, Talk und Kaolin, Aluminiumoxid oder Titanoxid; Calciumcarbonat; Nitriden, wie Siliciumnitrid, Bornitrid und Aluminiumnitrid; Karbiden, wie Siliciumcarbid; Whiskern und Mischungen davon.

7. Verwendung nach Anspruch 6, **dadurch gekennzeichnet, dass** die Füllmittel von 5 bis 80 Gew.-%, vorzugsweise von 10 bis 60 Gew.-% und noch mehr bevorzugt von 20 bis 50 Gew.-%, bezogen auf das Gesamtgewicht der Zusammensetzung, darstellen.

8. Verfahren zur Herstellung von elektrisch isolierenden Teilen, umfassend:
a) die in der Wärme erfolgende Herstellung einer Zusammensetzung, die ein wärmehärtbares Epoxidharz, ein Härtungsmittel und mindestens einen organischen nichtmetallischen Katalysator mit Vitrimerwirkung umfasst, ausgehend von der Zusammensetzung wie derjenigen, die in einem der Ansprüche 1 bis 7 definiert ist,
b) gegebenenfalls das In-Kontakt-Bringen der Zusammensetzung aus Schritt (a) mit mindestens einem elektrisch leitenden Element,
c) die Formgebung der Zusammensetzung aus Schritt a),
d) das Anlegen einer Energie, die das Härten des Harzes ermöglicht,
e) das Abkühlen des wärmegehärteten Harzes.

9. Elektrisch isolierendes Teil, erhalten nach dem Verfahren nach Anspruch 8.

## Claims

1. The use of a composition including, apart from a thermosetting resin of epoxy type and a curing agent chosen from carboxylic acid anhydrides having at least one -C(O)-O-C(O)- function, at least one vitrimer-effect nonmetallic organic catalyst at a content ranging from 0.1 to 10 mol%, relative to the molar amount of epoxy functional groups present in the thermosetting resin, said catalyst being chosen from the compounds of guanidine type corresponding to the formula (I): 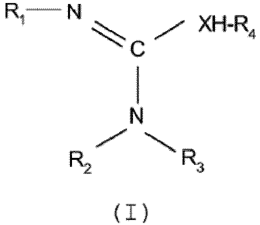 wherein:
X denotes a nitrogen atom,
R₁ denotes a hydrogen atom, a C₁-C₆ alkyl group or a phenyl group that can be substituted with a C₁-C₄ alkyl group,
R₂, R₃ and R₄ independently denote a hydrogen atom, a C₁-C₆ alkyl group, or a phenyl group that can be substituted with a C₁-C₄ alkyl group, or an acetyl group,
or R₁ and R₂ form, together and with the atoms with which they are bonded, an unsaturated heterocycle, and/or R₃ and R₄ form, together and with the atoms to which they are bonded, a saturated or unsaturated heterocycle;
for the manufacture of electrical insulation parts chosen from: an electrical insulator of electrical or electronic components, in the molded form or in the form of a matrix, coating, seal or adhesive, and in particular an adhesive for printed patch boards, a matrix resin for prepregs, or a resin for the coating or encapsulation of transistors, diodes, transformers or integrated circuits.

2. The use as claimed in claim 1, **characterised in that** the thermosetting resin is the bisphenol A diglycidyl ether (BADGE).

3. The use as claimed in either one of claims 1 and 2, **characterised in that** the curing agent is chosen from cyclic anhydrides, such as phthalic anhydride, nadic or methyl nadic anhydride, dodecenylsuccinic anhydride (DDSA), glutaric anhydride; partially or totally hydrogenated aromatic anhydrides such as tetrahydrophthalic or methyltetrahydrophthalic anhydride, hexahydrophthalic or methylhexahydrophthalic anhydride; anhydrides such as succinic anhydride, maleic anhydride, trimellitic anhydride, the adduct of trimellitic anhydride and of ethyleneglycol, chlorendic anhydride, tetrachlorophthalic anhydride, pyromellitic dianhydride (PMDA), 1,2,3,4 cyclopentanetetracarboxylic acid dianhydride; aliphatic acid polyanhydrides such as polyazelaic polyanhydride, polysebacic polyanhydride, and mixtures thereof.

4. The use as claimed in any one of the preceding claims, **characterised in that** the vitrimer-effect catalyst is chosen from the compounds triazabicyclodecene (TBD), di(ortho-tolyl)guanidine (DOTG) or 1,3-diphenylguanidine (DPG); preferably, the catalyst is triazabicyclodecene (TBD).

5. The use as claimed in any one of the preceding claims, **characterised in that** the catalyst represents from 0.1 to less than 5 mol%, more preferably from 0.5 to 2 mol%, relative to the molar amount of epoxy functional groups present in said thermosetting resin.

6. The use as claimed in any one of the preceding claims, **characterised in that** the composition additionally includes at least one filler chosen from: inorganic oxides, inorganic hydroxides and inorganic oxyhydroxides, such as silica, quartz, silicates, such as clays, talc and kaolin, alumina or titanium oxide; calcium carbonate; nitrides, such as silicon nitride, boron nitride and aluminum nitride; carbides, such as silicon carbide; whiskers; and mixtures thereof.

7. The use as claimed in claim 6, **characterised in that** the fillers represent from 5 to 80% by weight, preferably from 10 to 60% by weight and more preferably from 20 to 50% by weight, with respect to the total weight of the composition.

8. A process for the manufacture of electrical insulation parts, comprising:
a) the preparation under hot conditions of a composition including a thermosetting resin of epoxy type, a curing agent and at least one vitrimer-effect nonmetallic organic catalyst, starting from the composition as defined in any one of claims 1 to 7,
b) optionally the bringing of the composition resulting from step a) into contact with at least one electrically conducting element,
c) the shaping of the composition resulting from step a),
d) the application of energy which makes possible the curing of the resin,
e) the cooling of the thermoset resin.

9. An electrical insulation part obtained according to the process as claimed in claim 8.
